# EUROPEAN PATENT APPLICATION

(11) **EP 1 369 953 A1**
(43) Date of publication of application: **10.12.2003**
(21) Application number: 03253478.6
(22) Date of filing: 03.06.2003
(51) Int. Cl.: H01Q 1/02, H01Q 1/42, H01Q 1/24, H05K 5/06, H04B 1/08, H05K 5/02

(54) **Hermetically sealed satellite-broadcast receiving converter having an air-releasing pore**

(30) Priority: 06.06.2002 JP 2002165489
(71) Applicant: ALPS ELECTRIC CO., LTD., Ota-ku Tokyo 145 (JP)
(72) Inventor: Harada, Hiroshi, Ota-ku, Tokyo 145 (JP); Ikeda, Tomoki, Ota-ku, Tokyo 145 (JP)
(74) Representative: Kensett, John Hinton

(57) **Abstract**

A satellite-broadcast receiving converter, in which an air-releasing pore (8d) is closed by giving rise to thermal deformation of a protruding portion (8e). Hence, it is sufficient to perform filling and drying of an adhesive agent only once. This makes a time needed for a work shorter than a time conventionally needed, and makes it possible to obtain a satellite-broadcast receiving converter with satisfactory work efficiency. The interior of cases (7, 8) expands and contracts depending on the outside environment; however, because a section having the pore is closed with the thermally deformed protruding portion, a strength higher than a strength of a conventional adhesive agent is exerted on this occasion, thereby making it possible to provide a hermetically sealed state over a long period without causing an air hole.

## Description

### BACKGROUND OF THE INVENTION

### FIELD OF THE INVENTION

The present invention relates to a satellite-broadcast receiving converter suitable for outside installation.

### DESCRIPTION OF THE RELATED ART

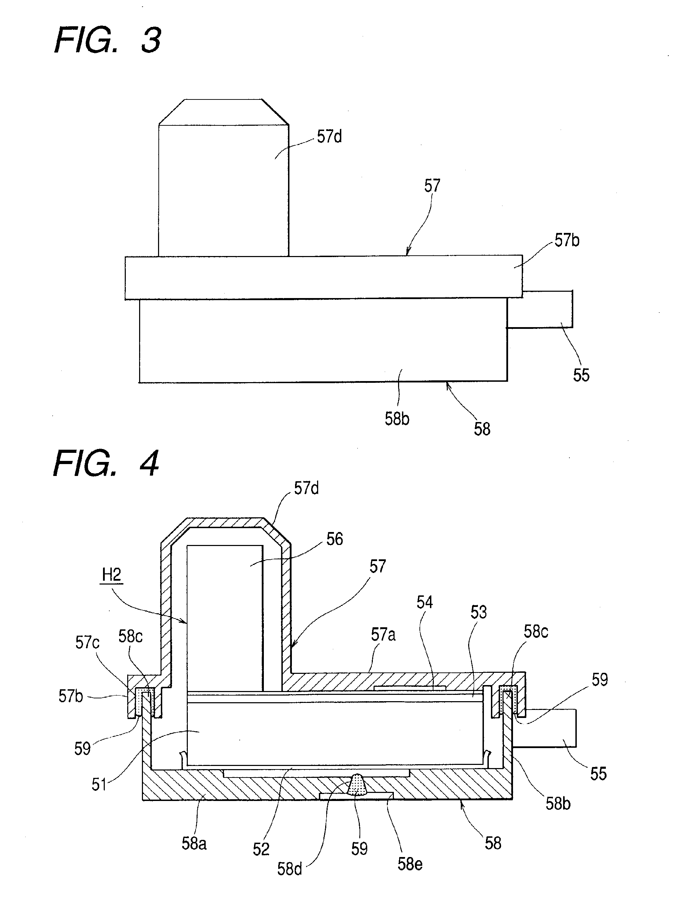

An arrangement of a conventional satellite-broadcast receiving converter will now be explained with reference to FIG. 3 and FIG. 4. A frame body 51 formed by bending a metal plate is shaped like a square box open at the top and the bottom.

A lid body 52 made of a metal plate is hooked and attached onto the frame body 51 so as to close one of the open portions of the frame body 51.

A circuit board 53 made of a printed circuit board includes a grounding pattern 54 formed almost across the entire surface on one side, and, although it is not shown in the drawings, a wiring pattern is provided on the other side. The wiring pattern is equipped with various electrical components, and thereby forms a desired receiving circuit.

The circuit board 53 arranged in this manner is attached to the frame body 51 so as to close the other open portion of the frame body 51 shaped like a square box with the electrical components (receiving circuit) being placed inside the frame body 51.

When the circuit board 53 is attached to the frame body 51, the grounding pattern 54 is exposed from the frame body 51 and shields the inside of the frame body 51. The receiving circuit is thus in a state electrically shielded by the frame body 51, the lid body 52, and the grounding pattern 54.

A coaxial connector 55 is attached to the frame body 51 while protruding outward from the frame body 51, and the receiving circuit is connected to the connector 55.

A feed horn 56 is attached to the grounding pattern 54 through soldering to stand upright from the circuit board 53. A converter main body H2 is obtained by the arrangement as above.

The converter main body H2 arranged in this manner receives satellite radio waves at the feed horn 56 and takes out a signal processed in the receiving circuit from the connector 55. Meanwhile, the converter main body H2 arranged in this manner has a low degree of hermetical sealing in the interior of the frame body 51, and for this reason, when used outdoors, it needs to be waterproofed in a secure manner as insurance against rain or the like.

A first case 57 made of a forming part of synthetic resin includes a top wall 57a, a sidewall 57b extending downward from the periphery of the top wall 57a, a groove portion 57c provided, at the lower end portion of the sidewall 57b, in a matching portion except for at least a lead-out section (not shown) through which the connector 55 is led to the outside, and a swelled portion 57d protruding from the top wall 57a in a vertical direction with an empty interior.

The first case 57 is placed to cover the entire upper portion of the converter main body H2 while accommodating the feed horn 56 inside the swelled portion 57d.

In this instance, part of the connector 55 protrudes to the outside of the first case 57 through the lead-out section.

A second case 58 made of a forming part of synthetic resin includes a bottom wall 58a, a sidewall 58b extending upward from the periphery of the bottom wall 58a, a protruding wall 58c provided, at the upper end portion of the sidewall 58b, in a matching portion except for at least a lead-out section (not shown) through which the connector 55 is led to the outside, a pore 58d provided to penetrate through the bottom wall 58a in allowing a communication between inside and outside, and a concave portion 58e provided to the outside surface of the bottom wall 58a to contain the pore 58d.

The second case 58 is placed to cover the entire lower portion of the converter main body H2. Also, the protruding wall 58c goes into the groove portion 57c filled with an adhesive agent 59, so that the matching portions of the first and second cases 57 and 58 are bonded to each other with the adhesive agent 59 except for the lead-out sections, which brings an interior of the first and second cases 57 and 58 into a hermetically sealed state.

In this instance, part of the connector 55 protrudes to the outside of the second case 58 through the lead-out section. However, the lead-out sections of the first and second cases 57 and 58 are closed with rubber packing attached to the connector 55 or with an adhesive agent.

When the second case 58 is assembled to the first case 57, the pore 58d is closed with the adhesive agent 59 in the last process after air inside is released to the outside through the pore 58d.

In order to improve the appearance of a section having the pore 58d, the pore 58d is hidden by attaching a label on the concave portion 58e.

An assembly method of the conventional satellite-broadcast receiving converter will now be explained. Initially, the first case 57 is held by a jig in a reversed state of the states shown in FIG. 3 and FIG. 4, and the groove portion 57c is filled with the adhesive agent 59 in this state.

Then, after the converter main body H2 is placed inside the first case 57 with the packing attached to the connector 55, the second case 58 is matched with the first case 57, whereupon air inside starts to flow to the outside through the pore 58d.

At the same time, the protruding wall 58c goes into the groove portion 57c and the adhesive agent 59, whereby the matching portion is closed.

When the interior is closed with the adhesive agent 59, the pore 58d allows air inside to be released, and thereby prevents the adhesive agent 59 in the groove 57c from flowing to the outside.

Then, in the last process after the adhesive agent 59 inside the groove portion 57c is dried to set, the pore 58d is closed by filling the pore 58d with the adhesive agent 59 followed by drying of the adhesive agent 59, whereupon the assembly is completed.

As has been described, the conventional satellite-broadcast receiving converter repeats the filling and the drying of the adhesive agent 59 twice: firstly for the groove portion 57c and secondly for the pore 58d. This raises a problem that not only the work is tedious, but also the work efficiency becomes poor due to a long time needed for the work.

Also, the interior of the cases expands and contracts depending on the outside environment, and on this occasion, an air hole is made due to a poor strength of the adhesive agent 59 at the section having the pore 58d, which raises a problem that a hermetical sealed state is deteriorated.

Also, because the tip end portion of the protruding wall 58c is of a planar shape, there is a problem that, when the protruding wall 58c goes into the adhesive agent 59, the adhesive agent 59 is pushed with so strong a force that the adhesive agent 59 in the groove portion 57c flows out.

### SUMMARY OF THE INVENTION

It is therefore an object of the invention to provide a satellite-broadcast receiving converter achieving satisfactory working efficiency and capable of maintaining a hermetically sealed state over a long period.

The above and other objects are achieved by a satellite-broadcast receiving converter of the invention, including a converter main body provided with a connector and first and second cases for accommodating the converter main body inside in a hermetically sealed state, wherein: one of the first and second cases is provided with a groove portion at a matching portion of the first and second cases except for a lead-out section through which the connector is led to an outside; the other one of the first and second cases is provided with a protruding wall that goes into the groove portion, the protruding wall being bonded to the groove portion with an adhesive agent filled in the groove portion in bringing an interior of the first and second cases into the hermetically sealed state; and at least one of the first and second cases includes an air-releasing pore and a protruding portion provided in close proximity to the pore, so that the pore is closed by giving rise to thermal deformation of the protruding portion.

According to this arrangement, for the air-releasing pore to be closed by giving rise to thermal deformation of the protruding portion, it is sufficient to perform the filling and the drying of the adhesive agent only once. This makes a time needed for a work shorter than a time conventionally needed, and makes it possible to obtain a satellite-broadcast receiving converter with satisfactory work efficiency.

Also, the interior of the cases expands and contracts depending on the outside environment; however, because the section having the pore is closed with the thermally deformed protruding portion, a strength higher than a strength of a conventional adhesive agent is exerted on this occasion, thereby making it possible to provide a hermetically sealed state over a long period without causing an air hole.

It may be arranged in such a manner that the protruding portion is formed as a cylindrical portion.

By forming the protruding portion as a cylindrical portion, it becomes easy to give rise to thermal deformation of the protruding portion. It is thus possible to close the pore in a reliable manner.

Also, it may be arranged in such a manner that a tip end portion of the protruding wall is formed wedge-wise.

By forming the tip end portion of the protruding wall wedge-wise, a less quantity of the adhesive agent is pushed outside when the protruding wall goes into the adhesive agent. It is thus possible to prevent the adhesive agent in the groove portion from flowing out.

Further, it may be arranged in such a manner that the groove portion is formed in the first case, and the protruding wall is formed in the second case.

By forming the groove portion in the first case, and the protruding wall in the second case, the first case can be placed above the second case. It is thus possible to eliminate collection of water in the groove portion.

Furthermore, it may be arranged in such a manner that the first case includes a plurality of holes in a sidewall positioned inside the second case, and the second case includes a plurality of protrusions on an inner portion of a sidewall, so that the protrusions snap-fit into the holes to be engaged.

By providing the first case with a plurality of holes in the sidewall positioned inside the second case, and the second case with a plurality of protrusions on the inner portion of a sidewall, so that the protrusions snap-fit into the holes to be engaged, the first and second cases can be readily assembled. It is thus possible to ensure the coupling of the first and second cases.

An embodiment of the present invention will now be described, by way of example only, with reference to the accompanying drawings, in which:
FIG. 1 is a front view of a satellite-broadcast receiving converter of the invention;
FIG. 2 is a cross section of a major portion of the satellite-broadcast receiving converter of the invention;
FIG. 3 is a front view of a conventional satellite-broadcast receiving converter; and
FIG. 4 is a cross section of a major portion of the conventional satellite-broadcast receiving converter.

### DETAILED DESCRIPTION OF THE INVENTION

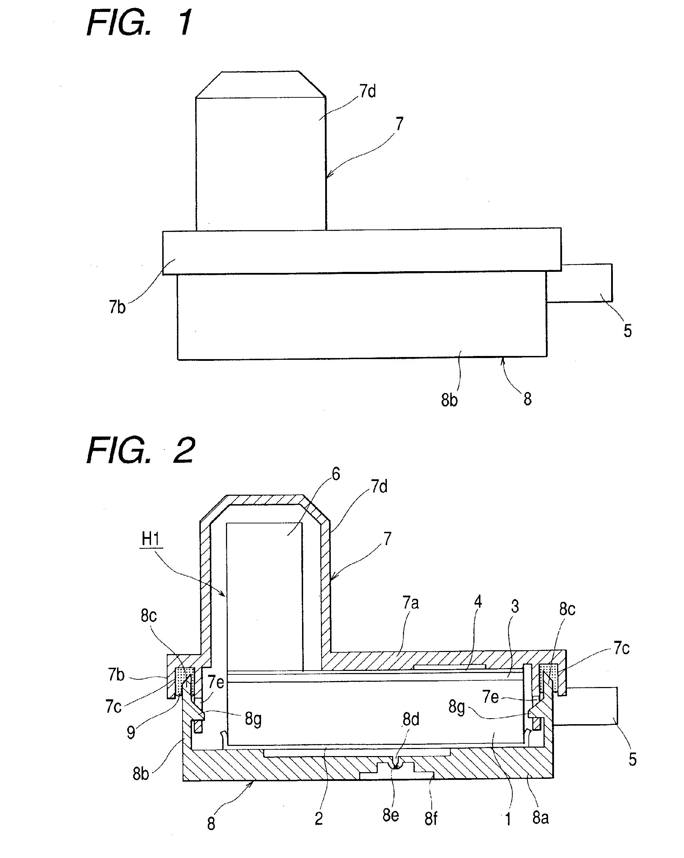

Drawings of a satellite-broadcast receiving converter of the invention will now be explained. FIG. 1 is a front view of the satellite-broadcast receiving converter of the invention, and FIG. 2 is a cross section of a major portion of the satellite-broadcast receiving converter of the invention.

An arrangement of the satellite-broadcast converter of the invention will now be explained with reference to FIG. 1 and FIG. 2. A frame body 1 formed by bending a metal plate is shaped like a square box open at the top and the bottom.

A lid body 2 made of a metal plate is hooked and attached onto the frame body 1 so as to close one of the open portions of the frame body 1.

A circuit board 3 made of a printed circuit board includes a grounding pattern 4 formed almost across the entire surface on one side, and, although it is not shown in the drawings, a wiring pattern is provided on the other side. The wiring pattern is equipped with various electrical components and thereby forms a desired receiving circuit.

The circuit board 3 arranged in this manner is attached to the frame body 1 so as to close the other open portion of the frame body 1 shaped like a square box with the electrical components (receiving circuit) being placed inside the frame body 1.

When the circuit board 3 is attached to the frame body 1, the grounding pattern 4 is exposed from the frame body 1 and shields the inside of the frame body 1. The receiving circuit is thus in a state electrically shielded by the frame body 1, the lid body 2, and the grounding pattern 4.

A coaxial connector 5 is attached to the frame body 1 while protruding outward from the frame body 1, and the receiving circuit is connected to the connector 5.

A feed horn 6 is attached to the grounding pattern 4 through soldering to stand upright from the circuit board 3. A converter main body H1 is obtained by the arrangement as above.

The converter main body H1 arranged in this manner receives satellite radio waves at the feed horn 6 and takes out a signal processed in the receiving circuit from the connector 5. Meanwhile, the converter main body H1 arranged in this manner has a low degree of hermetical sealing in the interior of the frame body 1, and for this reason, when used outdoors, it needs to be waterproofed in a secure manner as insurance against rain or the like.

A first case 7 made of a forming part of synthetic resin includes a top wall 7a, a sidewall 7b extending downward from the periphery of the top wall 7a, a groove portion 7c provided, at the lower end portion of the sidewall 7b, in a matching portion except for at least a lead-out section (not shown) through which the connector 5 is led to the outside, a swelled portion 7d protruding from the top wall 7a in a vertical direction with an empty interior, and a plurality of holes 7e provided to the sidewall 7b positioned inner than the groove portion 7c.

The first case 7 is placed to cover the entire upper portion of the converter main body H1 while accommodating the feed horn 6 inside the swelled portion 7d.

In this instance, part of the connector 5 protrudes to the outside of the first case 7 through the lead-out section.

A second case 8 made of a forming part of synthetic resin includes a bottom wall 8a, a sidewall 8b extending upward from the periphery of the bottom wall 8a, a wedge-like protruding wall 8c having a pointed edge portion provided, at the upper end portion of the sidewall 8b, in a matching portion except for at least a lead-out section (not shown) through which the connector 5 is led to the outside, a pore 8d provided to penetrate through the bottom wall 8a in allowing a communication between inside and outside, a cylindrical protruding portion 8e provided to the outer periphery of the pore 8d, a concave portion 8f provided to the outside surface of the bottom wall 8a to contain the pore 8e, and a plurality of protrusions 8g provided to the inner surface of the sidewall 8b.

The second case 8 is placed to cover the entire lower portion of the converter main body H1. Also, the protruding wall 8c goes into the groove portion 7c filled with an adhesive agent 9, so that the matching portions of the first and second cases 7 and 8 are bonded to each other with the adhesive agent 9 except for the lead-out sections, which brings an interior of the first and second cases 7 and 8 into a hermetically sealed state.

Also, it is arranged in such a manner that, when the first and second cases 7 and 8 are assembled, the sidewall 7b of the first case 7, which is positioned on the inner side of the groove portion 7c, is positioned inside the sidewall 8b of the second case 8. This allows the protrusions 8g to snap-fit in the pores 7e to be engaged, and the second case 8 is thereby hooked on the first case 7.

In this instance, part of the connector 5 protrudes to the outside of the second case 8 through the lead-out section. However, the lead-out sections of the first and second cases 7 and 8 are closed with rubber packing attached to the connector 5 or with an adhesive agent.

When the second case 8 is assembled to the first case 7, the pore 8d is closed by giving rise thermal deformation of the protruding portion 8e in the last process after air inside is released to the outside through the pore 8d.

In order to improve the appearance of a section having the pore 8d, the pore 8d is hidden by attaching a label on the concave portion 8f.

An assembly method of the satellite-broadcast receiving converter of the invention will now be explained. Initially, the first case 7 is held by a jig in a reversed state of the states shown in FIG. 1 and FIG. 2, and the groove portion 7c is filled with the adhesive agent 9 in this state.

Then, after the converter main body H1 is placed inside the first case 7 with the packing attached to the connector 5, the second case 8 is matched with the first case 7, whereupon air inside starts to flow to the outside through the pore 8d.

At the same time, the protruding wall 8c goes into the groove portion 7c and the adhesive agent 9, whereupon not only the matching portions are closed, but also the protrusions 8g snap-fit into the holes 7e to be engaged, and the second case 8 is thereby hooked on the first case 7.

When the interior is closed with the adhesive agent 9, the pore 8d allows air inside to be released, and thereby prevents the adhesive agent 9 in the groove 7c from flowing to the outside.

Then, after the adhesive agent 9 inside the groove portion 7c is dried to set, the pore 8d is closed by giving rise to thermal deformation of the protruding portions 8e with a heated jig in the last process, whereupon the assembly is completed.

The above embodiment described an example where the pore 8d and the protruding portion 8e are provided to the second case 8. However, the pore 8d and the protruding portion 8e may be provided to the first case 7.

Also, the above embodiment described an example where the groove portion 7c is provided to the first case 7 and the protruding wall 8c to the second case 8. However, a protruding wall may be provided to the first case 7 and a groove portion may be provided to the second case 8.

## Claims

1. A satellite-broadcast receiving converter, comprising:
a converter main body provided with a connector; and first and second cases for accommodating the converter main body inside in a hermetically sealed state, wherein:
one of said first and second cases is provided with a groove portion at a matching portion of said first and second cases except for a lead-out section through which said connector is led to an outside;
the other one of said first and second cases is provided with a protruding wall that goes into said groove portion, said protruding wall being bonded to said groove portion with an adhesive agent filled in said groove portion in bringing an interior of said first and second cases into the hermetically sealed state; and
at least one of said first and second cases includes an air-releasing pore and a protruding portion provided in close proximity to said pore, so that said pore is closed by giving rise to thermal deformation of said protruding portion.

2. The satellite-broadcast receiving converter according to Claim 1, wherein said protruding portion is formed as a cylindrical portion.

3. The satellite-broadcast receiving converter according to Claim 1 or 2, wherein a tip end portion of said protruding wall is formed wedge-wise.

4. The satellite-broadcast receiving converter according to any of Claims 1 to 3, wherein said groove portion is formed in said first case, and said protruding wall is formed in said second case.

5. The satellite-broadcast receiving converter according to Claim 4, wherein said first case includes a plurality of holes in a sidewall positioned inside said second case, and said second case includes a plurality of protrusions on an inner portion of a sidewall, so that said protrusions snap-fit into said holes to be engaged.
